# EUROPEAN PATENT APPLICATION

(11) **EP 1 708 022 A1**
(43) Date of publication of application: **04.10.2006**
(21) Application number: 05019006.5
(22) Date of filing: 01.09.2005
(51) Int. Cl.: G03F 7/00

(54) **Nanoimprint lithograph for fabricating nanopattern in a resist layer**

(30) Priority: 29.03.2005 CN 200510062488; 25.07.2005 CN 200510084933
(71) Applicant: Lee, Bing-Huan, Niaosong Township Kao hsiung 833 (TW)
(72) Inventor: Chao, Chih-Yu, Taipei City 106 (TW); Hsieh, Wen-Jiunn, Jhonghe City Taipei County 235 (TW)
(74) Representative: Becker Kurig Straus

(57) **Abstract**

A nanoimprint lithography method of fabricating a nanoadhesive includes steps of (a) preparing a substrate and a mold under the vacuum environment, wherein at least one of the substrate and the mold is transparent, the mold is located over the substrate and has an oppressing portion having nanometer-scale features and a mold release agent located on the surface of the nanometer-scale features; (b) coating a liquid resist cast on the substrate, wherein the resist cast can be hardened by ultraviolet rays; (c) having the mold is pressed on the substrate to enable the resist cast to fill between the nanometer-scale features and the substrate; (d) irradiating the resist cast by the ultraviolet rays for hardening; and (e) releasing the mold from the substrate to enable the resist cast to produce a contrast pattern thereon corresponding to the nanometer-scale features, wherein the resist cast with the contrast pattern is the nanoadhesive.

## Description

### BACKGROUND OF THE INVENTION

### 1. Field of the Invention

The present invention relates generally to nanotechnology, and more particularly, to low-cost and high-throughput nanoimprint lithography of fabricating a nanoadhesive.

### 2. Description of the Related Art

In the field of the nanotechnology, the imprint lithography techniques can meet the requirements of mass production and low production cost. Particularly, the imprint lithography technique with the sub-50-nm line-width is essential for the further manufacturing of semiconductor integrated circuits and the commercialization of electronic, optoelectronic, and magnetic nanodevices.

Numerous relevant technologies are under development, like scanning electro beam lithography (K. C. Beard, T. Qi. M. R. Dawson, B. Wang. C. Li, Nature 368, 604 (1994)), X-ray lithography (M. Godinot and M. Mahboubi, C. R. Acad. Sci. Ser. II Mec. Phys. Chim. Chim. Sci. Terre Univers. 319, 357(1994); M. Godinot, in Anthropoid Origins, J. G. Fleagle and R. F. Kay, Eds. (Plenum, New York, 1994), pp. 235-295), lithographies based on scanning proximal probes (E. L. Simons and D. T. Rasmussen, Proc. Nati. Acad. Sci. U.S.A. 91, 9946(1994); Evol. Anthropol. 3, 128 (1994)), etc. While the scanning electro beam lithography demonstrated 10-nm resolution, it exposes point by point in a serial manner and thus, the current throughput of the technique is too low to be economically practical for mass production. The X-ray lithography demonstrated 20-nm resolution in a contact printing mode and has a high throughput, but its mask technology and exposure systems are currently rather complex and expensive. The lithographies based on scanning proximal probes, demonstrated a resolution of about 10-nm, but were in the early stages of development and failed to meet the requirements of low production cost and mass production, either.

### SUMMARY OF THE INVENTION

The primary objective of the present invention is to provide a low-cost and high-throughput nanoimprint lithography method of fabricating a nanoadhesive.

The foregoing objective of the present invention is attained by the nanoimprint lithography method, which includes the steps of:
preparing a substrate and a mold under the vacuum environment, wherein at least one of the substrate and the mold is transparent, the mold is located over the substrate and has nanometer-scale features located on its bottom side, and a mold release agent located on the surface of the nanometer-scale features;
coating a liquid resist cast on the substrate, wherein the resist cast can be hardened by the irradiation of ultraviolet rays; pressing the mold onto the substrate to enable the resist cast to fill between the nanometer-scale features and the substrate;
irradiating the transparent one of the mold and the substrate by the ultraviolet rays to enable the ultraviolet rays to penetrate it to irradiate and harden the resist cast;
and releasing the mold from the substrate, and meanwhile, the resist cast produces a contrast pattern thereon corresponding to the nanometer-scale features, wherein the resist cast with the contrast pattern is the nanoadhesive.

### BRIEF DESCRIPTION OF THE DRAWINGS

FIG. 1 is a schematic view of the first step of a first preferred embodiment of the present invention.
FIG. 2 is a schematic view of the second step of the first preferred embodiment of the present invention.
FIG. 3 is a schematic view of the third step of the first preferred embodiment of the present invention.
FIG 4 is a schematic view of the forth step of the first preferred embodiment of the present invention.
FIG 5 is a schematic view of the fifth step of the first preferred embodiment of the present invention.
FIG 6 is a schematic view of the first step of a second preferred embodiment of the present invention.
FIG 7 is a schematic view of the second step of the second preferred embodiment of the present invention.
FIG. 8 is a schematic view of the third step of the second preferred embodiment of the present invention.
FIG 9 is a schematic view of the forth step of the second preferred embodiment of the present invention.
FIG 10 is a schematic view of the fifth step of the second preferred embodiment of the present invention.
FIG 11 is a schematic view of the first step of a third preferred embodiment of the present invention.
FIG 12 is a schematic view of the second step of the third preferred embodiment of the present invention.
FIG 13 is a schematic view of the third step of the third preferred embodiment of the present invention.
FIG. 14 is a schematic view of the fourth step of the third preferred embodiment of the present invention.
FIG 15 is a schematic view of the fifth step of the third preferred embodiment of the present invention.

### DETAILED DESCRIPTION OF PREFERRED EMBODIMENTS

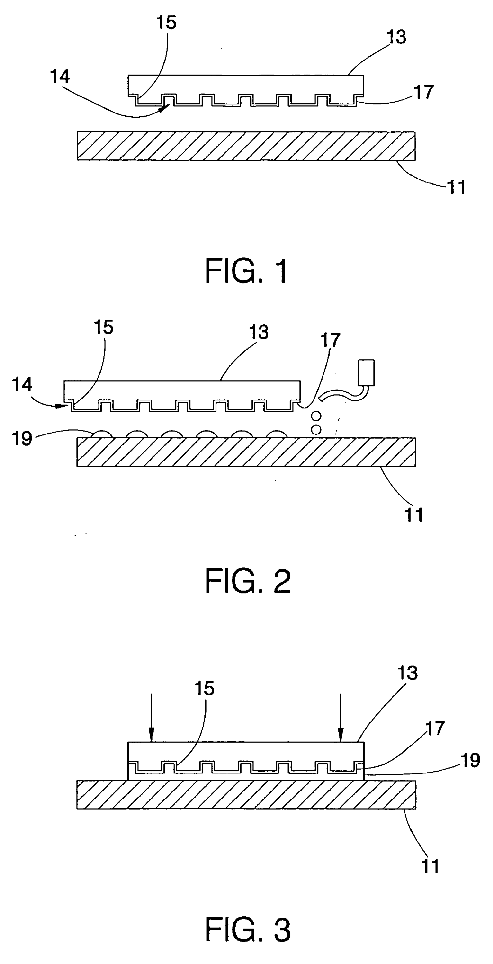

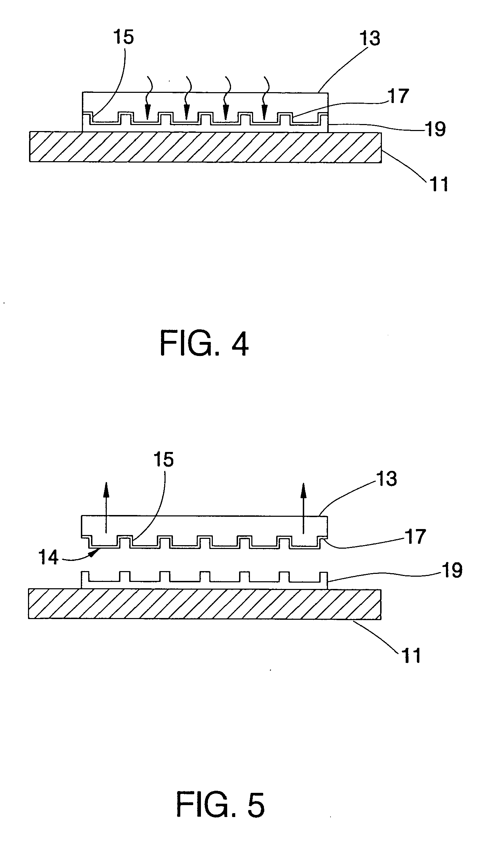

Referring to FIGS. 1-5, a nanoimprint lithography method of fabricating a nanoadhesive constructed according to a first preferred embodiment of the present invention includes the follows steps.
(a) Under vacuum environment, prepare a substrate 11 and a mold 13. The mold 13 is transparent plate-like and located over the substrate 11, having an oppressing portion 14 on a bottom side thereof. The oppressing portion 14 has nanometer-scale features 15 on its surface and a mold release agent 17 on the surface of the nanometer-scale features 15, as shown in FIG 1.
(b) Coat a liquid resist cast 19 on the substrate 11. The resist cast 19 is a polymer in this embodiment and can be hardened by the irradiation of ultraviolet rays. As shown in FIG 2, the resist cast 19 like water drops is dropped on the substrate 11 and then coated on the substrate 11 evenly by spinning coating. Since the spinning coating is known as the prior art, no further discussion of this process is necessary.
(c) Press the mold 13 onto the substrate 11 to enable the resist cast 19 to fill between the nanometer-scale features 15 and the substrate 11, as shown in FIG 3.
(d) Irradiate the mold 13 by the ultraviolet rays from the upper side to enable the ultraviolet rays to penetrate the mold 13 to irradiate and harden the resist cast 19, as shown in FIG. 4.
(e) Release the mold 13 from the substrate 11 to enable the resist cast 19 to produce a contrast pattern corresponding to the nanometer-scale features 15, wherein the resist cast 19 with the contrast pattern is the nanoadhesive, as shown in FIG 5.

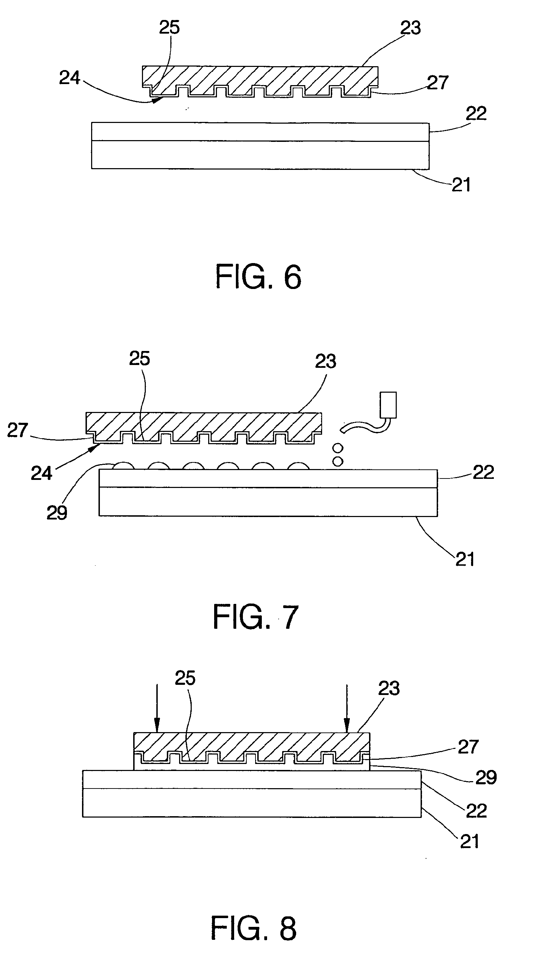

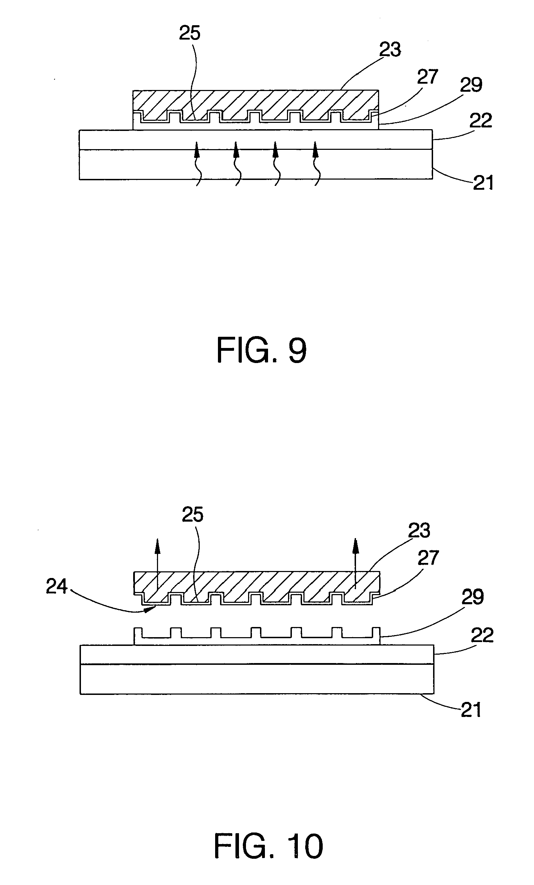

Referring to FIGS. 6-10, the nanoimprint lithography method of fabricating the nanoadhesive in accordance with a second preferred embodiment of the present invention is described and is similar to the first preferred embodiment but different in that a release layer 22 is coated on the substrate 21. The steps of this embodiment are recited below.
(a) Under a vacuum environment, prepare a substrate 21 and a mold 23. The substrate 21 is transparent, having a release layer 22 applied on its surface. The mold 23 is located over the substrate 21, having an oppressing portion 24 on a bottom side thereof. The oppressing portion 24 has nanometer-scale features 25 on its surface and a mold release agent 27 on the surface of the nanometer-scale features 25, as shown in FIG 6.
(b) Coat a liquid resist cast 29 on the release layer 22. The resist cast 29 can be hardened by the irradiation of ultraviolet rays. As shown in FIG 7, the resist cast 29 like water drops is dropped on the substrate 21 and then coated on the substrate 21 evenly by spinning coating. Since the spinning coating is known as the prior art, no further discussion of this technique is necessary.
(c) Press the oppressing portion 24 of the mold 23 onto the substrate 21 to enable the resist cast 29 to fill between the nanometer-scale features 25 and the release layer 22, as shown in FIG 8.
(d) Irradiate the substrate 21 with the ultraviolet rays from the lower side to enable the ultraviolet rays to penetrate the substrate 21 to irradiate and harden the resist cast 29, as shown in FIG 9.
(e) Release the mold 23 from the substrate 21 to enable the resist cast 29 to produce a contrast pattern corresponding to the nanometer-scale features 25, wherein the resist cast 29 with the contrast pattern is the nanoadhesive, as shown in FIG. 10. The mold 23 is made of soluble polymers and thus can be removed by a solvent. For example, PVA (Polyvinyl Acetate) is a polymeric material to be water-soluble and thus can be solubilized by water to be removed from the substrate 21. Thus, the mold 23 can be released from the substrate 21 without damage to the resist cast 29, greatly enhancing the quality of the resist cast 29.

After the steps indicated above, remove the release layer 22 together with the resist cast 29 from the substrate 21 to enable the release layer 22 to become a carrier of the resist cast 29 for other purposes. Further, the release layer 22 can be erosively eliminated from the substrate by a chemical agent, and meanwhile, the resist cast 29 is kept on the substrate 21.

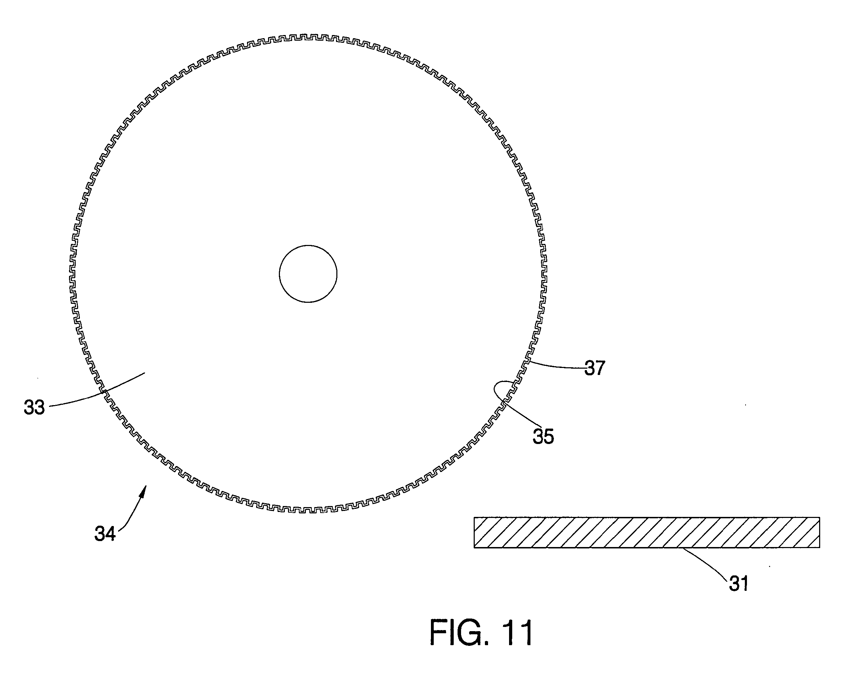

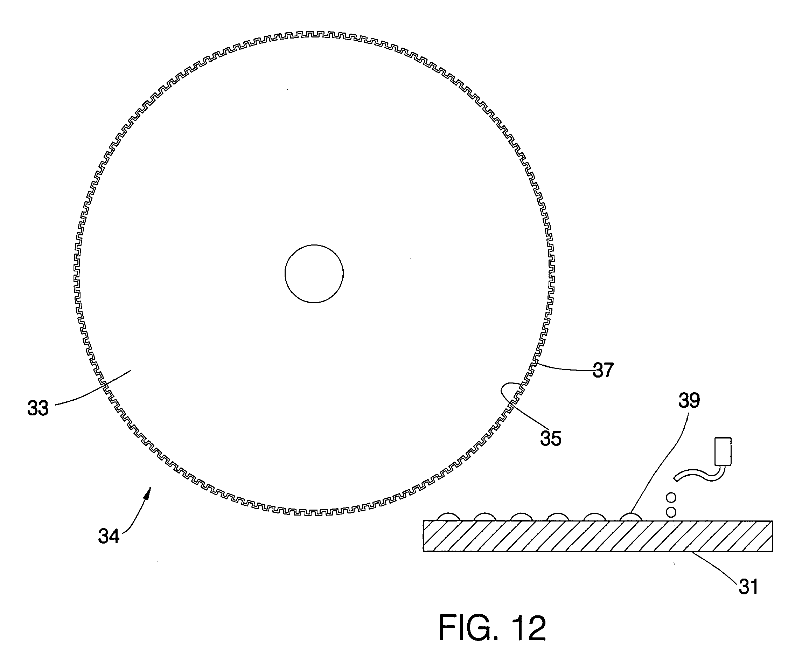

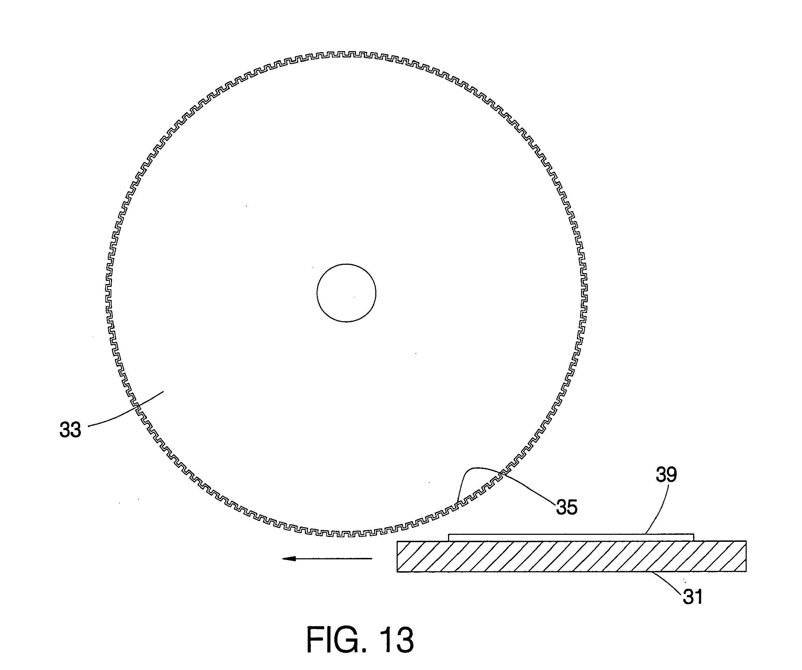

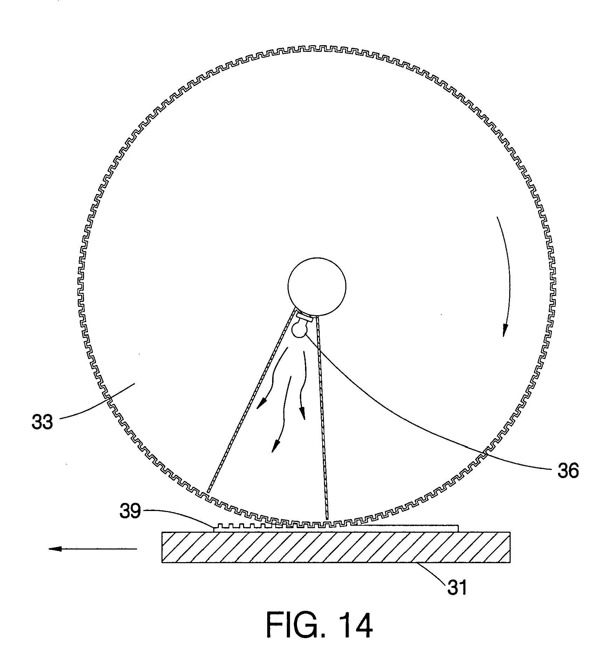

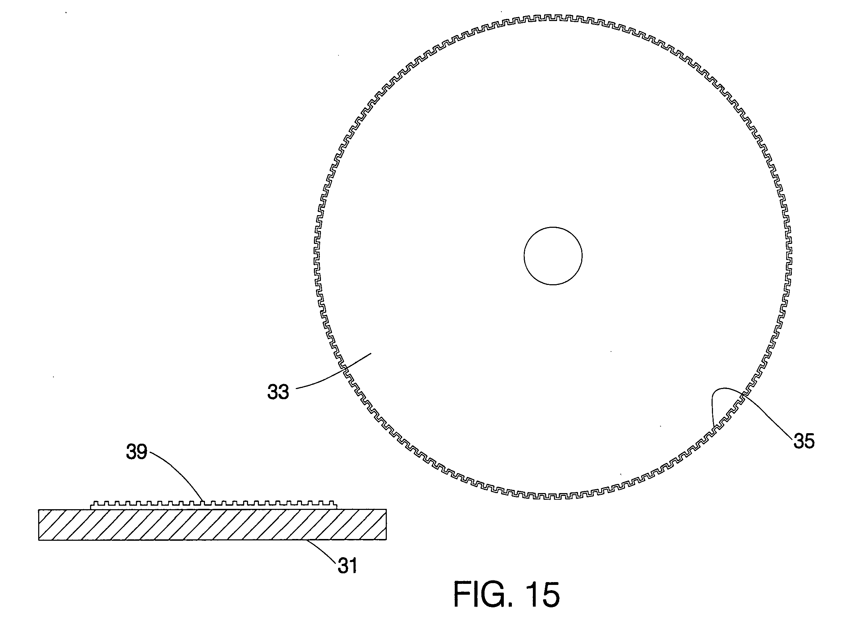

Referring to FIGS. 11-15, the nanoimprint lithography method of fabricating the nanoadhesive in accordance with a third preferred embodiment of the present invention is similar to the aforementioned preferred embodiment but different by that the mold 33 is roller-shaped and the oppressing portion 34 is located on an outer periphery of the mold 33 for rolling the substrate 31. The steps of this embodiment are recited below.
(a) Under vacuum environment, prepare a substrate 31 and a mold 33. The mold 13 is transparent roller-shaped and located over the substrate 31, having an oppressing portion 34 on an outer periphery thereof. The oppressing portion 34 has nanometer-scale features 15 on a surface thereof and a mold release agent 37 on the surface of the nanometer-scale features 35, as shown in FIG. 11.
(b) Lay a liquid resist cast 39 on the substrate 31. The resist cast 39 is a polymer in this embodiment and can be hardened by the irradiation of ultraviolet rays. As shown in FIG 12, the resist cast 39 like water drops is dropped on the substrate 31 and then coated on the substrate 31 evenly by spinning coating. Since the spinning coating is known as prior art, no further recitation is necessary.
(c) Let the mold 33 roll the substrate 31 to enable the resist cast 39 to be filled between the nanometer-scale features 35 and the substrate 31, as shown in FIG. 13.
(d) Irradiate the mold 33 by the ultraviolet rays from upper side to enable the ultraviolet rays to penetrate the mold 33 to irradiate and harden the resist cast 39 while the mold 33 rolls the substrate 31, as shown in FIG 14. The ultraviolet rays are generated by an ultraviolet source 36 located in said roller-shaped mold 33 and facing downward.
(e) Release the mold 33 by rolling the mold 33 away from the substrate 31. In the meantime, a contrast pattern corresponding to the nanometer-scale features 35 is formed on the resist cast 39. Thus, the resist cast 39 with the contrast pattern is the nanoadhesive, as shown in FIG. 15.

After the steps indicated above, unfix the resist cast 39 with contrast pattern in the step (e) and then the resist cast 39 can be used for the nanoadhesive.

As indicated above, the nanoimprint lithography method of fabricating the nanoadhesive of the present invention employs the simple imprint or roller-print lithography in cooperation with the liquid resist cast and the irradiation of the ultraviolet rays under the vacuum environment to create a great number of nanometer-scale hardened resist casts for fabrication of the nanoadhesive. Thus, the present invention can achieve both of the mass production and low production cost, far more advanced than the prior art.

## Claims

1. A nanoimprint lithography method of fabricating a nanoadhesive, comprising the steps of:
(a) preparing a substrate and a mold under the vacuum environment, wherein at least one of said substrate and said mold is transparent, said mold is located over said substrate, and said mold has an oppressing portion having nanometer-scale features, said nanometer-scale features having a mold release agent laid on their surface; and
(b) coating a liquid resist cast on said substrate, wherein said resist cast can be hardened by irradiation of ultraviolet rays;.
(c) pressing said oppressing portion of said mold onto said substrate to enable said resist cast to fill between said nanometer-scale features and said substrate;
(d) irradiating said mold or said substrate that is transparent, by ultraviolet rays to enable said ultraviolet rays to penetrate it to irradiate and harden said resist cast;
(e) releasing said mold from said substrate to enable said resist cast to produce a contrast pattern corresponding to said nanometer-scale features, wherein said resist cast with said contrast pattern is said nanoadhesive.

2. The nanoimprint lithography method as defined in claim 1, wherein said substrate comprises a release layer laid on its surface.

3. The nanoimprint lithography method as defined in claim 1, wherein said resist cast is a polymer in the step (b).

4. The nanoimprint lithography method as defined in claim 1. wherein said substrate is transparent in the step (a).

5. The nanoimprint lithography method as defined in claim 1, wherein said mold is transparent in the step (a).

6. The nanoimprint lithography method as defined in claim 1, wherein said mold in the step (a) is plate-like; said oppressing portion in the step (a) is located on a bottom side of said mold.

7. The nanoimprint lithography method as defined in claim 6, wherein said mold in the step (e) is made of soluble polymers and can be solubilized by a solvent.

8. The nanoimprint lithography method as defined in claim 7, wherein said mold in the step (e) is water-soluble and can be removed from said substrate by water.

9. The nanoimprint lithography method as defined in claim 7, wherein said mold in the step (a) is roller-shaped and said oppressing portion is located on an outer periphery of said mold, said mold having said oppressing portion roll said substrate in the step (c).
